(19) Europäisches Patentamt

European Patent Office

Office européen des brevets

(11) EP 0 838 845 B1

(12) **FASCICULE DE BREVET EUROPEEN**

(45) Date de publication et mention de la délivrance du brevet:
**02.01.2002 Bulletin 2002/01**

(51) Int Cl.7: **H01L 21/3105**, H01L 21/306, C09G 1/02

(21) Numéro de dépôt: **97402355.8**

(22) Date de dépôt: **07.10.1997**

(54) **Nouveau procédé de polissage mécano-chimique de couches de matériaux isolants à base de dérivés du silicium ou de silicium**

Neues Verfahren zum chemisch mechanischen Polieren von Isolationsschichten aus Silizium oder Silizium enthaltenden Materialien

New process for chemical mechanical polishing of isolating layers based on silicon or silicon containing materials

(84) Etats contractants désignés:
**AT BE CH DE DK ES FI FR GB IE IT LI LU MC NL SE**

(30) Priorité: **23.10.1996 FR 9612892**

(43) Date de publication de la demande:
**29.04.1998 Bulletin 1998/18**

(73) Titulaire: **Clariant Finance (BVI) Limited Road Town, Tortola (VG)**

(72) Inventeurs:
• **Jacquinot, Eric**
**60350 Trosly Breuil (FR)**
• **Rivoire, Maurice**
**38240 Meylan (FR)**

(74) Mandataire: **D'haemer, Jan Constant Clariant International Ltd., Rothausstrasse 61 4132 Muttenz 1 (CH)**

(56) Documents cités:
**EP-A- 0 401 147** **US-A- 3 620 978**
**US-A- 4 944 836** **US-A- 5 264 010**
**US-A- 5 340 370**

## Description

La présente invention concerne la technique d'aplanissement par le polissage mécano-chimique d'un matériau d'isolement électrique applicable à l'isolation des circuits intégrés.

Dans le cadre de la réduction des dimensions et de l'augmentation de la densité dans le domaine de la micro-électronique, les techniques d'isolation évoluent. Ainsi aux techniques d'isolation des zones actives à base d'oxydation localisée, ont succédé les techniques d'isolement latéral desdites zones actives par tranchées peu profondes comprenant les étapes de gravure de ces tranchées, de remplissage par le dépôt de l'isolant et l'aplanissement de cette couche isolante.

La principale difficulté liée à ces techniques d'isolation est l'aplanissement de la couche du matériau isolant.

Il apparaît que le polissage mécano-chimique est la solution la plus performante pour cette étape du procédé d'aplanissement. Il présente l'avantage par rapport aux techniques conventionnelles de gravure liquide ou par plasma, de graver les matériaux en aplanissant très efficacement les reliefs initiaux.

La présente invention concerne une amélioration des étapes d'aplanissement de l'oxyde de silicium utilisé pour la fabrication des circuits intégrés au niveau de l'isolation latérale (STI : Shallow Trench Isolation) et au niveau de l'isolement des interconnections (ILD, Inter-Level Dielectrics).

La technique du polissage mécano-chimique combine deux effets influant sur l'attaque de l'isolant, à savoir un effet mécanique et un effet chimique.

L'effet mécanique résulte de la force d'appui de la plaquette de matériau semi-conducteur sur un tissu de polissage, des vitesses de déplacement (par exemple de rotation) relatif de la plaquette et du tissu, des caractéristiques de ce tissu et du diamètre des particules de silice de l'abrasif.

L'effet chimique résulte essentiellement de la chimie de surface de la silice colloïdale.

Ces deux effets conjugués provoquent le retrait des molécules du matériau poli préférentiellement sur les zones en relief en induisant l'aplanissement du matériau à polir.

Pour le polissage d'un matériau isolant à base de dérivés du silicium tels que le dioxyde de silicium ou le nitrure de silicium, on emploie généralement un abrasif constitué de solutions aqueuses basiques de particules colloïdales de silice pyrogénées, appelées également fumées de silice.

Ces silices pyrogénées sont obtenues à partir de procédés pyrogéniques par combustion de tétrachlorosilane de haute pureté avec de l'hydrogène et de l'oxygène dans une chambre à combustion à haute température.

On obtient habituellement des particules primaires de silice sphériques de 5 à 50 nanomètres qui forment des agrégats de particules de longueur généralement comprise entre 50 à 500 nanomètres.

Dans la littérature, il a été décrit que, lors du polissage mécano-chimique d'un isolant à base de dérivés du silicium, tout particulièrement à base de dioxyde de silicium, la vitesse d'attaque de l'isolant à l'aide de silices pyrogénées était d'autant plus importante que le diamètre des particules de silice colloïdale utilisée était important, et que le pH de la solution de silice colloïdale utilisée était élevé (voir en particulier R. Jairath et al, Mat; Res. Soc. Symp. Proc. vol 337, 1994, p121-31, G.J Pietsch et al, Surface Science 331-333 (1995) p.395 - 401, M. Borda et al, Dumic Conference 21-22,2,1995 p.331-337, D. DeVlieger et al, Conference Proceedings ULSI-X 1995, Materials Research Society, p.201-205, W.J. Patrick et al, J. Electrochem. Soc., vol. 138, n°6, June 1991, p.1778-1784, R. Kolenkow et al, Solid State Technology, June 1992, p. 112-114, Beyer, Klaus Dietrich EP 224646, Sears George Wallace Jr, US 3.922.393, Doan Trung T. US 5169491, Koto Itsuki JP 07316846 ).

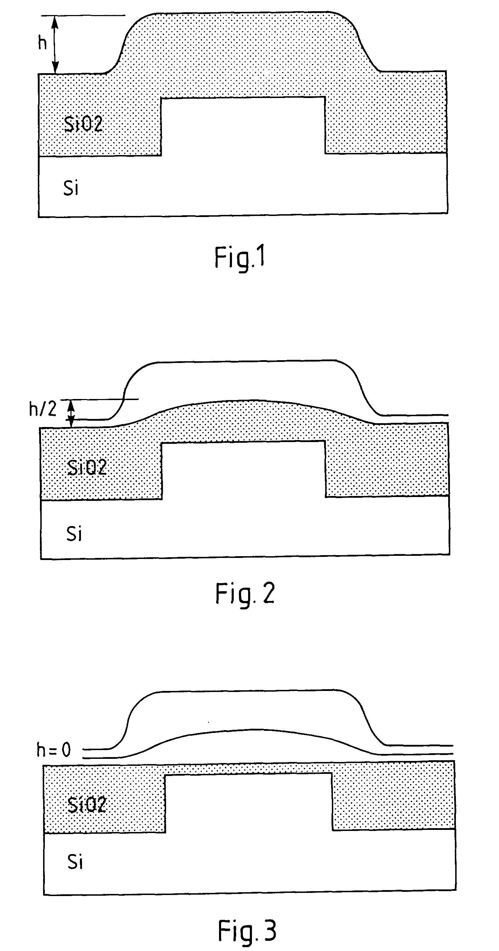

Les pH les plus couramment utilisés se situent entre 9 et 12,5. Par contre à pH acide les vitesses d'attaque sont particulièrement faibles, voir en particulier la figure 1. de l'article de G.J. Pietsch et al, Surface Science 331-333 (1995) p. 396.

L'utilisation de telles suspensions aqueuses en milieu fortement basique présente un certain nombre d'inconvénients. Tout d'abord du fait de la distribution large de la longueur des agrégats, il y a une tendance à la sédimentation de ces dernières au cours du temps, inconvénient qui ne peut être minimisé que par une agitation constante de la suspension. En outre l'utilisation de suspensions aqueuses fortement basiques présente toujours des inconvénients dans le domaine de l'environnement et des conditions de travail.

La demanderesse s'est donc donné pour but principal une amélioration de l'aplanissement des couches de dioxyde de silicium dans les procédés d'isolement que l'on peut rencontrer dans la fabrication des circuits intégrés, par exemple dans les procédés d'isolement latéral par tranchées peu profondes des futures zones actives du substrat semi-conducteur, ainsi que dans d'autres procédés d'isolement de circuits intégrés qui nécessitent un aplanissement parfait du dioxyde de silicium. Ceci englobe également l'isolement des interconnexions des circuits intégrés par du dioxyde de silicium.

Pour réaliser toutes ces améliorations dans le polissage mécano-chimique effectué avec des suspensions aqueuses basiques de silice colloïdale, il a été constaté de façon surprenante et inattendue que des suspensions de silice colloïdale, comprenant ou constituées de fines particules individualisées de silice non liées entre elles par des liaisons siloxanes et utilisées en milieu acide permettaient d'obtenir des effets d'aplanissement très améliorés tout en conservant une bonne vitesse d'attaque du matériau isolant, ainsi que d'excellentes qualités d'uniformité d'attaque du polissage.

C'est pourquoi la présente invention a pour objet l'utilisation d'un abrasif qui comprend une suspension aqueuse acide de silice colloïdale contenant des particules de silice colloïdale individualisées, non liées entre elles par des liaisons siloxanes, et de l'eau comme milieu de suspension pour le polissage mécano-chimique de couches à base de silicium ou de dérivés du silicium, plus particulièrement le polissage mécano-chimique de couches de dioxyde de silicium, ainsi qu'un procédé de polissage mécano-chimique d'une couche de matériau isolant à base de silicium ou d'un dérivé du silicium, dans lequel l'on procède à une abrasion de la couche de matériau isolant en frottant ladite couche à l'aide d'un tissu comprenant un abrasif, caractérisé en ce que l'abrasif comprend une suspension aqueuse acide de silice colloïdale comprenant des particules individualisées de silice colloïdale, non liées entre elles par des liaisons siloxanes, et de l'eau comme milieu de suspension et est de préférence essentiellement constitué d'une telle suspension aqueuse acide.

Ces suspensions aqueuses de silice colloïdale comprennent ou sont constituées de fines particules individualisées de silice, non liées entre elles par des liaisons siloxanes, en suspension dans de l'eau et sont de préférence substantiellement dépourvues d'agrégats de particules. Pour le polissage mécano-chimique des couches de matériaux selon l'invention, les suspensions aqueuses de silice colloïdale sont utilisées en milieu acide, et possèdent de préférence des diamètres de particules individuelles compris entre 3 et 250 nm notamment entre 3 et 150 nm, particulièrement entre 10 et 50 nm.

De telles suspensions aqueuses de silice colloïdale peuvent être obtenues, soit à partir de silicates alcalins, en particulier, de sodium ou de potassium, soit à partir de silicate d'éthyle. Dans les deux cas, à partir des moyens connus de l'homme de l'art et décrits plus particulièrement par K.K lier, dans "The Chemistry of Silica", chapitre 9, pages 331 à 343, Ed. Wiley Interscience 1979, on peut obtenir des suspensions aqueuses acides de silice colloïdale contenant des particules individualisées, non liées entre elles par des liaisons de type siloxane de diamètre compris entre 3 et 250 nm.

Un avantage principal de l'invention est l'amélioration du polissage mécano-chimique de couches de matériau isolant tel le dioxyde de silicium par des suspensions aqueuses acides de silice colloïdale.

Cette amélioration peut être par exemple essentiellement démontrée par 3 types de tests :

a) des tests de vitesse d'attaque des couches de dioxyde de silicium par la dispersion aqueuse d'abrasif de silice colloïdale. Cette vitesse d'attaque est mesurée, par la différence de mesures d'épaisseurs avant et après polissage, sur une plaque de dioxyde de silicium dépourvue de motifs. La vitesse d'attaque est exprimée en Å/min.

b) des tests d'aplanissement, en particulier le degré d'aplanissement (DA) caractérisant la variation de la hauteur de marche entre le relief initial (avant polissage) et le relief final (après polissage), mesuré sur des plaques comportant des motifs isolés d'une hauteur initiale de 7000 Å. Il s'exprime en pourcentage et est défini par la formule suivante:

$$DA = 100 \times \frac{Hi - Hf}{Hi}$$

avec

Hi = Hauteur de marche initiale
Hf = Hauteur de marche finale

Un aplanissement total donne un degré d'aplanissement total de 100 %. Un aplanissement nul donne un degré d'aplanissement de 0 %.

Les figures 1, 2 et 3 illustrent la définition du degré d'aplanissement. Le degré d'aplanissement est de 0% dans la figure 1, de 50% dans la figure 2 et de 100% dans la figure 3.

Pour tous les tests d'aplanissement, l'épaisseur enlevée dans les parties basses (hors motif) a été ajustée à 3500 Å.

c) des tests d'uniformité d'attaque du polissage. Celle-ci représente la variation d'épaisseur d'oxyde sur une même plaque. Elle est calculée à partir de mesures d'oxyde sur une même plaque de $SiO_2$ avant et après polissage selon la formule suivante :

$$U = \frac{\text{Epaisseur Maxi - Epaisseur Mini}}{2 \times \text{Epaisseur moyenne enlevée}} \times 100$$

Plus la valeur obtenue est basse, plus l'uniformité d'attaque est satisfaisante.

Ce procédé de polissage avantageux est réalisé grâce à des suspensions aqueuses acides de silice colloïdale particulières, constituées de particules individualisées, non liées entre elles par des liaisons siloxanes.

Dans les conditions préférentielles de mise en oeuvre du procédé selon l'invention, on utilise des suspensions aqueuses acides de silice colloïdale ayant un pH compris entre 1 et 6, notamment entre 1,5 et 4, particulièrement entre 2 et 3.

Dans d'autres conditions préférentielles de mise en oeuvre du procédé selon l'invention, les diamètres des particules élémentaires des suspensions de silice colloïdale sont compris entre 3 et 250 nm, notamment entre 3 et 150 nm, particulièrement entre 10 et 50 nm.

Afin d'obtenir le meilleur rendement de polissage en particulier pour les deux tests principaux retenus : vitesse d'attaque des couches de dioxyde de silicium et qualité de l'aplanissement des couches traitées, dans encore d'autres conditions préférentielles de mise en oeuvre, la concentration pondérale en produit de polissage, c'est à dire de silice, est de 5 à 50 %, préférentiellement de 15 à 30 %.

La couche de matériau isolant est de préférence à base de dioxyde de silicium, le nitrure de silicium, de polysilicium, ou de silicium amorphe et plus particulièrement à base de dioxyde de silicium.

Un autre avantage de l'invention est que les suspensions aqueuses acides de silice colloïdale, constituées de particules individualisées, non liées entre elles par des liaisons siloxanes et possédant des diamètres de particules pratiquement monodisperses, ont une très bonne stabilité dans le temps, d'où résulte l'absence de sédimentation au cours du temps.

Les exemples suivants permettront de mieux comprendre l'invention.

EXEMPLE 1 : Exemple de polissage avec des abrasifs à base de suspensions aqueuses acides de silice colloïdale selon l'invention -

Sur chaque plaquette étudiée est réalisé un dépôt de dioxyde de silicium d'environ 1 μm qui est ensuite mesuré avant polissage.

La plaquette est ensuite polie grâce au procédé standard suivant :

- force d'appui : 0,5 daN/cm$^2$
- vitesse plateau : 25 tours/mn
- vitesse tête (carrier) : 22 tours/mn
- température : 20°C
- débit d'abrasif : 80 cm$^3$ /mn
- tissu: IC 1000 sur Suba 4 de RODEL PRODUCTS

Les résultats indiqués dans chaque exemple sont obtenus à partir d'une plaquette de dioxyde de silicium pleine plaque pour les vitesses d'attaque, et pour le pourcentage d'uniformité d'attaque, et d'une plaquette structurée pour déterminer le degré d'aplanissement .

Avec une silice colloïdale dont les caractéristiques sont les suivantes :

- diamètre moyen des particules élémentaires de silice colloïdale : 12 nm
- pH de la suspension aqueuse : 2,2
- concentration pondérale en silice colloïdale : 20 %

on obtient :

- un degré d'aplanissement de 78 %
- une vitesse d'attaque de SiO$_2$ de 1050 Å/mn
- un pourcentage d'uniformité d'attaque de 3 %.

Dans les mêmes conditions en utilisant une silice colloïdale, dont les caractéristiques sont les suivantes :

- diamètre moyen des particules élémentaires de silice colloïdale : 25 nm
- pH de la suspension aqueuse : 2,2
- concentration pondérale en silice colloïdale : 20 %

on obtient :

- un degré d'aplanissement de 52 %
- une vitesse d'attaque de SiO$_2$ de 1850 Å/min.
- un pourcentage d'uniformité d'attaque de 2,5 %

Expérimentation 1 : Exemple de comparaison de polissage avec des abrasifs à base de suspensions aqueuses basiques de silice colloïdale

Le procédé de polissage est réalisé dans les conditions ci-dessus, mais la concentration pondérale en silice a été ajustée à 12 - 13 %.

Avec une silice colloïdale pyrogénée commerciale pour cette application dont les caractéristiques sont les suivantes :

- diamètre moyen des particules élémentaires : 10 nm
- diamètres particules agrégats moyens : 150 nm
- pH de la suspension aqueuse : 10,3
- concentration pondérale en produit actif : 12 %

on obtient:

- un degré d'aplanissement de 42 %
- une vitesse d'attaque de SiO$_2$ de 1100 Å/mn
- un pourcentage d'uniformité d'attaque de 8,5 %.

Avec une silice colloïdale pyrogénée commerciale pour cette application dont les caractéristiques sont les suivantes :

- diamètre moyen des particules élémentaires : 25 nm
- diamètre particules agrégats moyen : 200 nm
- pH de la suspension aqueuse : 10,2
- concentration pondérale en produit actif : 13 %

on obtient :

- un degré d'aplanissement de 56 %
- une vitesse d'attaque de SiO$_2$ de 1500 Å/mn
- un pourcentage d'uniformité d'attaque de 11, 5%.

On constate donc d'une part, que contrairement à ce qui est annoncé dans la littérature, et de façon inattendue, l'on peut obtenir, avec les suspensions aqueuses acides de silice colloïdale, des vitesses d'attaque de la couche de dioxyde de silicium du même ordre de grandeur que les suspensions aqueuses basiques de silice colloïdale précédemment utilisées.

On voit également d'autre part que de façon tout aussi inattendue les suspensions aqueuses acides de silice colloïdale donnent des effets d'aplanissement très largement supérieurs à ceux obtenus avec des suspensions aqueuses basiques de silice colloïdale pyrogénée et que de façon très surprenante ce sont les suspensions aqueuses acides à base de petites particules qui donnent les meilleurs résultats de tous les produits testés.

Enfin, on a pu mettre en évidence une très bonne uniformité d'attaque des suspensions aqueuses acides de silice colloïdale selon l'invention par rapport aux suspensions aqueuses basiques de silice colloïdale pyrogénée.

## Revendications

1. Procédé de polissage mécano-chimique d'une couche de matériau isolant à base de silicium ou d'un dérivé du silicium, dans lequel l'on procède à une abrasion de la couche de matériau isolant en frottant ladite couche à l'aide d'un tissu comprenant un abrasif, **caractérisé en ce que** l'abrasif comprend une suspension aqueuse acide de silice colloïdale contenant des particules de silice colloïdale individualisées, non liées entre elles par des liaisons siloxanes, et de l'eau comme milieu de suspension.

2. Procédé selon la revendication 1, **caractérisé par le fait que** la suspension aqueuse acide de silice colloïdale a un pH compris entre 1 et 6.

3. Procédé selon la revendication 2, **caractérisé par le fait que** la suspension aqueuse acide de silice colloïdale a un pH compris entre 2 et 3.

4. Procédé selon l'une des revendications 1 à 3, **caractérisé par le fait que** la suspension aqueuse acide de silice colloïdale comprend des particules individualisées non liées entre elles par des liaisons siloxanes, de diamètre compris entre 3 et 250 nanomètres.

5. Procédé selon la revendication 4, **caractérisé par le fait que** la suspension aqueuse acide de silice colloïdale comprend des particules individualisées non liées entre elles par des liaisons siloxanes, de diamètre compris entre 10 et 50 nanomètres.

6. Procédé selon l'une des revendications 1 à 5, **caractérisé par le fait que** la suspension aqueuse acide de silice colloïdale est utilisée à une concentration pondérale en silice comprise entre 5 et 50 %.

7. Procédé selon la revendication 6, **caractérisé par le fait que** la suspension aqueuse acide de silice colloïdale est utilisée à une concentration pondérale en silice comprise entre 15 et 30 %.

8. Procédé selon l'une des revendications 1 à 7, **caractérisé par le fait que** la couche de matériau isolant à base silicium ou de dérivés de silicium est à base de dioxyde de silicium, de nitrure de silicium, de polysilicium, ou de silicium amorphe.

9. Procédé selon la revendication 8, **caractérisé par le fait que** la couche de matériau isolant est à base de dioxyde de silicium.

## Patentansprüche

1. Verfahren zum chemisch-mechanischen Polieren einer Schicht aus Isoliermaterial auf Basis von Silicium oder einem Siliciumderivat, bei dem man die Schicht aus Isoliermaterial durch Reiben mit einem ein Schleifmittel enthaltenden Tuch schleift, **dadurch gekennzeichnet, dass** das Schleifmittel eine saure wässrige Suspension von kolloidaler Kieselsäure mit individualisierten, nicht über Siloxanbindungen miteinander verknüpften Teilchen von kolloidaler Kieselsäure und Wasser als Suspensionsmedium enthält.

2. Verfahren nach Anspruch 1, **dadurch gekennzeichnet, dass** die saure wässrige Suspension von kolloidaler Kieselsäure einen pH-Wert zwischen 1 und 6 aufweist.

3. Verfahren nach Anspruch 2, **dadurch gekennzeichnet, dass** die saure wässrige Suspension von kolloidaler Kieselsäure einen pH-Wert zwischen 2 und 3 aufweist.

4. Verfahren nach einem der Ansprüche 1 bis 3, **dadurch gekennzeichnet, dass** die saure wässrige Suspension von kolloidaler Kieselsäure individualisierte, nicht über Siloxanbindungen miteinander verknüpfte Teilchen von kolloidaler Kieselsäure mit einem Durchmesser zwischen 3 und 250 nm enthält.

5. Verfahren nach Anspruch 4, **dadurch gekennzeichnet, dass** die saure wässrige Suspension von kolloidaler Kieselsäure individualisierte, nicht über Siloxanbindungen miteinander verknüpfte Teilchen von kolloidaler Kieselsäure mit einem Durchmesser zwischen 10 und 50 nm enthält.

6. Verfahren nach einem der Ansprüche 1 bis 5, **dadurch gekennzeichnet, dass** man die saure wässrige Suspension von kolloidaler Kieselsäure mit einer Kieselsäure-Konzentration zwischen 5 und 50 Gew.-% einsetzt.

**7.** Verfahren nach Anspruch 6, **dadurch gekennzeichnet, dass** man die saure wässrige Suspension von kolloidaler Kieselsäure mit einer Kieselsäure-Konzentration zwischen 15 und 30 Gew.-% einsetzt.

**8.** Verfahren nach einem der Ansprüche 1 bis 7, **dadurch gekennzeichnet, dass** die Schicht aus Isoliermaterial auf Basis von Silicium oder Siliciumderivaten auf Siliciumdioxid, Siliciumnitrid, Polysilicium oder amorphem Silicium basiert.

**9.** Verfahren nach Anspruch 8, **dadurch gekennzeichnet, dass** die Isoliermaterialschicht auf Siliciumdioxid basiert.

**Claims**

**1.** Chemical mechanical polishing process for a layer of isolating material based on silicon or a silicon derivative, in which an abrasion of the isolating material layer is carried out by rubbing said layer using a fabric containing an abrasive, **characterized in that** the abrasive comprises an acidic aqueous suspension of colloidal silica containing individualized colloidal silica particles, not linked together by siloxane bonds, and water as suspension medium.

**2.** Process according to Claim 1, **characterized in that** the acidic aqueous suspension of colloidal silica has a pH between 1 and 6.

**3.** Process according to Claim 2, **characterized in that** the acidic aqueous suspension of colloidal silica has a pH between 2 and 3.

**4.** Process according to any of Claims 1 to 3, **characterized in that** the acidic aqueous suspension of colloidal silica contains individualized particles not linked together by siloxane bonds, with a diameter between 3 and 250 nanometres.

**5.** Process according to Claim 4, **characterized in that** the acidic aqueous suspension of colloidal silica contains individualized particles not linked together by siloxane bonds, with a diameter between 10 and 50 nanometres.

**6.** Process according to any of Claims 1 to 5, to **characterized in that** the acidic aqueous suspension of colloidal silica is used at a silica concentration of between 5 and 50% by weight.

**7.** Process according to Claim 6, **characterized in that** the acidic aqueous suspension of colloidal silica is used at a silica concentration of between 15 and 30% by weight.

**8.** Process according to any of Claims 1 to 7, **characterized in that** the layer of isolating material based on silicon or silicon derivatives is based on silicon dioxide, silicon nitride, polysilicon or amorphous silicon.

**9.** Process according to Claim 8, **characterized in that** the layer of isolating material is based on silicon dioxide.

Fig.1

Fig. 2

Fig. 3